Europäisches Patentamt

European Patent Office

Office européen des brevets

(11) Veröffentlichungsnummer : **0 159 407**
**B1**

(12) EUROPÄISCHE PATENTSCHRIFT

(45) Veröffentlichungstag der Patentschrift :
17.05.89

(51) Int. Cl.⁴ : **H 05 K 9/00**

(21) Anmeldenummer : 84115849.6

(22) Anmeldetag : 19.12.84

(54) Kontaktvorrichtung zwischen gegeneinander beweglichen Gehäuseteilen von elektromagnetisch abgeschirmten Räumen oder Kabinen.

(30) Priorität : 19.04.84 DE 3415024

(43) Veröffentlichungstag der Anmeldung :
30.10.85 Patentblatt 85/44

(45) Bekanntmachung des Hinweises auf die Patenterteilung : 17.05.89 Patentblatt 89/20

(84) Benannte Vertragsstaaten :
BE DE FR GB IT NL SE

(56) Entgegenhaltungen :
DE–B– 2 451 192
GB–A– 936 891
US–A– 3 594 490
US–A– 4 110 552

(73) Patentinhaber : Siemens Aktiengesellschaft Berlin
und München
Wittelsbacherplatz 2
D-8000 München 2 (DE)

(72) Erfinder : Biena, Richard. Ing.grad.
Sudentenweg 5
D-8411 Wenzenbach (DE)
Erfinder : Schaller, Rudolf. Dipl.-Ing.
Süd-Ring 17
D-8401 Alteglofsheim (DE)

## Beschreibung

Die Erfindung betrifft eine Kontaktvorrichtung zwischen gegeneinander beweglichen Bauteilen von elektromagnetisch abgeschirmten Räumen oder Kabinen, insbesondere von Türen oder Fenstern, bei der an dem einen Bauteil ein Federschacht, in den Kontaktfedern eingelegt sind, die einen guten elektrischen Kontakt mit diesem Bauteil aufweisen, und an dem anderen Bauteil ein messerartiger Fortsatz vorgesehen sind, der in Schließstellung in den Federschacht hineinragt, so daß die Kontaktfedern an ihm federnd anliegen. Eine Kontaktvorrichtung dieser Art ist durch die DE-AS 24 51 192 bekannt.

In der Fernmelde- und Hochfrequenztechnik wird teils gefordert, die Ausbreitung elektrischer und magnetischer Felder in bestimmte Raumbereiche zu verhindern, in denen sie störende Wirkungen ausüben können. So sind ggf. elektrische Geräte, z. B. Rundfunkempfänger oder empfindliche Meßgeräte, vor elektrischen Störeinflüssen durch Einbau in elektromagnetisch abgeschirmte Gehäuse oder Kabinen zu schützen oder auch ganze Räume abschirmsicher auszustatten. Elektrostatische Felder können schon durch dünne Metallfolien völlig abgeschirmt werden, während magnetostatische Felder in Räumen mit Wänden aus ferromagnetischen Materialien abgeschwächt werden.

Da die Abschirmung an Kontaktstellen zwischen festen und beweglichen Raumabschirmungen, z. B. zwischen Fensterrahmen und Fensterflügeln bzw. zwischen Türzargen und Türblättern, geringer ist als an lückenlos geschlossenen Wandfeldern, stellen diese Kontaktstellen im allgemeinen die dämpfungsärmsten Bereiche dar. Es besteht daher die Forderung, diese Kontaktbereiche den jeweiligen Gegebenheiten anzupassen, und die Abschirmung entsprechend zu verbessern.

In der GB-PS 9 36 891 ist eine Kontaktvorrichtung für hochfrequenzbeheizte Apparaturen beschrieben. Die am Deckel der Apparatur befindliche Kontaktvorrichtung besteht aus einer Rinne, längs deren inneren Seitenwände blattartige Kontaktfedern befestigt sind. Demgegenüber ist die Apparatur am Öffnungsrand mit einer Lippe ausgestattet, welche bei geschlossener Apparatur sich innerhalb der Rinne befindet und die dort befestigten Federbleche gegen die Seitenwände der Rinne drückt. Federkontakte und Lippe sind außerdem so gestaltet, daß stets eine Neigung zum Öffnen der Apparatur besteht, welcher durch geeignete Mittel, z. B. mit Hilfe von Elektromagneten entgegengewirkt wird.

Durch die DE-OS 21 34 815 ist eine Gehäuseanordnung für elektrische Einrichtungen zur Abschirmung gegen elektromagnetische Wellen bekannt, bei der die Anlageflächen zwischen den Türen und den Gehäuseteilen elektrisch leitende Metallstreifen aufweisen, an welche in geschlossenem Zustand des Gehäuses Anlagewulste angedrückt werden. Bei einer weiteren dort beschriebenen Ausführungsform ist die Auflagefläche des Gehäuses als u-förmiger Kanal ausgebildet, in dem Anlagewulste untergebracht sind. Beim Schließen des Gehäuses greift eine an der Tür befestigte Messerschiene in den Anlagewulst ein und bildet mit diesem eine Klemmverbindung. Das DE-GBM 70 09 828 beschreibt eine Hochfrequenzabdichtung zur Überbrückung von Fugen in Gehäuseteilen für elektrische Geräte. In eine Nut des Gehäuses eingelegt befindet sich dabei ein gefiedertes Federblech, welches mit der Rückseite an einem hochgezogenen Steg der Nut flächig anliegt und bis auf den Boden der Nut reicht, wo es abgewinkelt ist. Außerdem befindet sich innerhalb der Nut eine elastische, den Boden der Nut bedeckende Einlage aus Magnetpulver. Bei der Überbrückung zweiter Gehäuseteile liegt die Stirnseite eines zweiten Gehäuseteils auf der elastischen Einlage der Nut auf. Diese Kontaktvorrichtung ist zur Überbrückung von Fugen in Gehäuseteilen geeignet, welche nur selten gelöst und wieder verbunden werden. Bei häufigem Öffnen und Schließen der Kontaktvorrichtung ist ein rascher Verschleiß des Materials zu verzeichnen.

Die eingangs genannte DE-AS 24 51 192 beschreibt schließlich eine Kontaktvorrichtung, bei der eine am Türblatt befindliche Nut zum Boden hin V-förmig verjüngt und dort abgeflacht ist. In diese Nut ist dabei eine ebenso V-förmig gebogene, einen größeren Öffnungswinkel aufweisende Schiene eingelegt, die auf jeder Seite der Nutöffnung je eine teilweise gefiederte, mehrfach abgewinkelte Blattfeder als Kontaktfeder festklemmt, in die ein am Türzargen angeordneter messerartiger, keilförmig gestalteter Fortsatz eintaucht.

Insbesondere auch bei der letztgenannten bekannten Kontaktvorrichtung wird eine möglichst gute elektrisch leitende und hochfrequenzdichte Kontaktierung der beteiligten Kontaktflächen, z. B. der Türzarge mit dem Türblatt gefordert. Die Elemente der Kontaktvorrichtungen, d. h. z. B. der Federschacht am Türblatt und der in diesen eintauchende messerartige Fortsatz an der Türzarge bestehen dabei aus feuerverzinktem Stahl. Durch die vorstehend beschriebenen Kontaktvorrichtungen, aber auch durch die guten elektrischen und magnetischen Eigenschaften des hierfür verwendeten feuerverzinkten Stahls werden Kabinen und Räume mit hohen Schirmwirkungs-Werten geschaffen. Unter ungünstigen klimatischen Bedingungen bilden sich jedoch auf den verzinkten Oberflächen des verwendeten Stahls elektrisch schlecht leitende Korrosionsprodukte, sog. Weißrost, welche die Schirmwirkung der Kontaktvorrichtung stark beeinträchtigen. Zur Beseitigung dieser Weißrostbildung wurden bisher die Kontaktflächen in regelmäßigen Zeitabständen gereinigt und anschließend eingefettet. Wurde diese Reinigung versäumt, so führte dies zu einer starken Herabsetzung der Schirmwirkung der Kontaktvorrichtung.

Der vorliegenden Erfindung liegt die Aufgabe zugrunde, eine Kontaktvorrichtung der eingangs genannten Art zu schaffen, die weitgehend unabhängig von klimatischen Einflüssen eine im wesentlichen konstante Schirmwirkung besitzt ; d. h. insbesondere auch nicht zur Bildung von Weißrost mit all den hiermit verbundenen Nachteilen neigt.

Zur Lösung dieser Aufgabe sieht die Erfindung bei einer Kontaktvorrichtung gemäß Oberbegriff des Patentanspruchs 1 vor, daß der Federschacht und messerartige Fortsatz bei Einsatz der Räume und Kabinen im unteren Frequenzbereich, d. h. im Bereich von ca. 10 kHz bis 1 MHz, aus unlegiertem Stahl und bei Einsatz der Räume und Kabinen im oberen Frequenzbereich, d. h. im Bereich von ca. 1 MHz bis 1 GHz, aus elektrisch gut leitendem Material, z. B. Kupfer oder Aluminium besteht, dessen Oberfläche jeweils zumindest im Kontaktbereich mit austenitischem Stahl, insbesondere Chromstahl oder Chromnickel-Stahl beschichtet ist.

Austenitischer Stahl ist praktisch nicht korrodierender und damit als Schutzüberzug äußerst geeigneter Stahl.

Eine Kontaktvorrichtung, die sowohl für den unteren wie auch den oberen Frequenzbereich geeignet ist, wird erhalten, wenn der aus unlegiertem Stahl bestehende Federschacht und messerartige Fortsatz zunächst mit einer Schicht aus elektrisch gut leitendem Material z. B. Kupfer oder Aluminium, und schließlich und zwar zumindest im Kontaktbereich mit einer zweiten Schicht aus austenitischem Stahl wie Chromstahl oder Chromnickel-Stahl beschichtet wird.

Die Erfindung wird nachstehend anhand eines Ausführungsbeispieles näher erläutert. Es zeigt :

Fig. 1 in teilweise geschnittener und gebrochener Ansicht eine Kontaktvorrichtung nach der Erfindung für eine Türzarge und ein Türblatt,

Fig. 2 die Kontaktvorrichtung nach Fig. 1 in der Darstellung nach Fig. 1, jedoch in vergrößertem Maßstab und in auseinandergezogener Stellung,

Fig. 3 die über der Frequenz aufgetragene Schirmwirkung, gemessen nach MIL-STD 285, für Kontaktvorrichtungen gemäß Fig. 1 und 2 mit jeweils unterschiedlichen Werkstoffen.

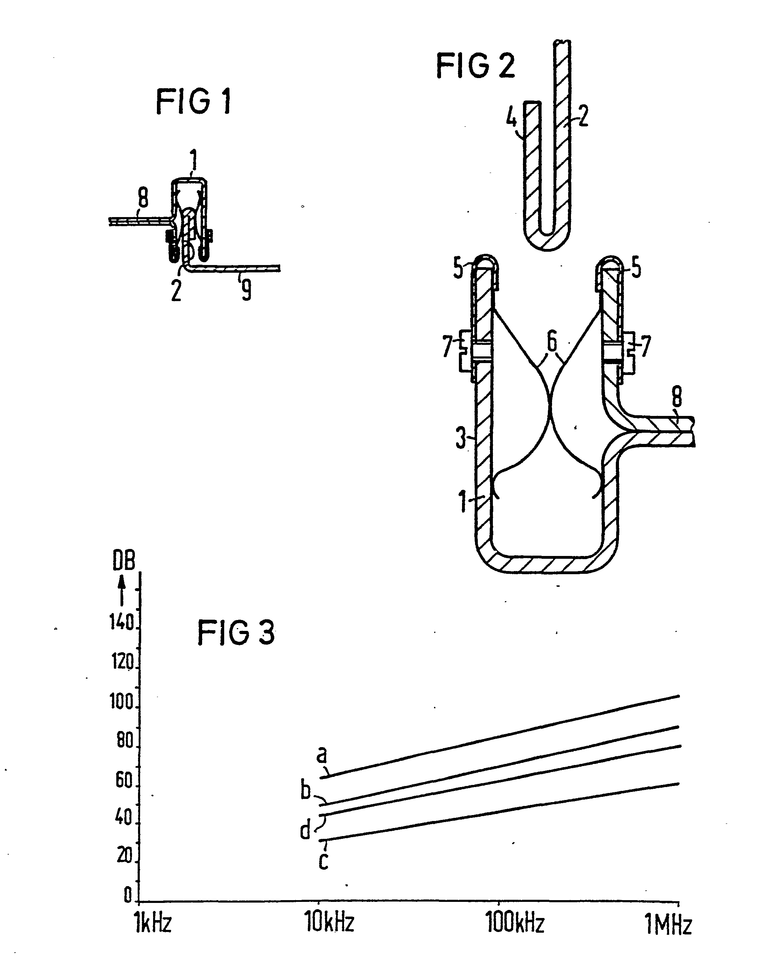

Die Fig. 1 und 2 zeigen eine, soweit es die konstruktiven Merkmale betrifft, an sich bekannte Kontaktvorrichtung mit einem Türblatt 8 mit einem Federschacht 1, auf dessen freie Enden Halterungsschienen für Blattfedern 6 aufgesteckt sind, die mittels Schrauben 7 mit dem Federschacht 1 verschraubt sind. Mit 2 ist ein messerartiger Fortsatz bezeichnet, der Teil einer Türzarge 9 ist.

Im gezeigten Ausführungsbeispiel sind der Federschacht 1 und der messerartige Fortsatz 2 aus unlegiertem Stahl gefertigt, der mit einer Schicht 3 bzw. 4 aus austenitischem Stahl, z. B. Chrom-Stahl oder Chromnickel-Stahl, beschichtet ist.

Fig. 3 gibt für unterschiedliche Werkstoffe für die Kontaktvorrichtung nach Fig. 1, 2 die Schirmwirkung wieder. Für feuerverzinkten Stahl — siehe Kurve a — ist diese am größten, sinkt jedoch — wie dies die Kurve d zeigt — bei korrodierten Oberfläche erheblich ab. Eine nochmalige Verschlechterung der Schirmwirkung tritt ein, wenn an Stelle von feuerverzinktem Stahl massiver Chrom-Stahl verwendet wird (siehe Kurve c).

Demgegenüber, d. h. insbesondere auch gegenüber korrodiertem feuerverzinktem Stahl zeigt eine Kontaktvorrichtung mit unlegiertem und mit Chrom-Stahl plattiertem Werkstoff wesentlich verbesserte Schirmwirkungs-Eigenschaften (siehe Kurve b).

**Patentansprüche**

1. Kontaktvorrichtung zwischen gegeneinander beweglichen Bauteilen von elektromagnetisch abgeschirmten Räumen oder Kabinen, insbesondere von Türen oder Fenstern, bei der an dem einen Bauteil ein Federschacht, in den Kontaktfedern eingelegt sind, die einen guten elektrischen Kontakt mit diesem Bauteil aufweisen, und an dem anderen Bauteil ein messerartiger Fortsatz vorgesehen sind, der in Schließstellung in den Federschacht hineinragt, so daß die Kontaktfedern an ihm federnd anliegen, dadurch gekennzeichnet, daß der Federschacht (1) und messerartige Fortsatz (2) bei Einsatz der Räume oder Kabinen im unteren Frequenzbereich aus unlegiertem Stahl und bei Einsatz der Räume und Kabinen im oberen Frequenzbereich aus elektrisch gut leitendem Material besteht, dessen Oberfläche jeweils zumindest im Kontaktbereich mit austenitischem Stahl (3, 4) beschichtet ist.

2. Kontaktvorrichtung nach Anspruch 1, dadurch gekennzeichnet, daß als elektrisch gut leitendes Material Kupfer oder Aluminium vorgesehen ist.

3. Kontaktvorrichtung nach Anspruch 1, dadurch gekennzeichnet, daß als austenitischer Stahl Chromstahl oder Chromnickel-Stahl vorgesehen ist.

4. Kontaktvorrichtung nach Anspruch 1 bis 3, dadurch gekennzeichnet, daß für den Einsatz der Räume oder Kabinen im gesamten Frequenzbereich der Federschacht (1) und messerartige Fortsatz (2) aus unlegiertem Stahl besteht, der mit einer ersten Schicht aus elektrisch gut leitendem Material und zumindest im Kontaktbereich mit einer zweiten Schicht aus austenitischem Stahl beschichtet ist.

**Claims**

1. Electrical contact device for use between mutually displacable structural parts of electromagnetically screened rooms or cabins, especially of doors or windows, in which one structural part is provided with a spring chamber, in which there are inserted contact springs which have a good electrical contact with this structural part, and in which the other structural part is provided with a knife-like extension which, in the closed position, projects into the spring chamber, so that the contact springs bear against it resiliently, characterized in that the spring chamber (1) and the knife-like extension (2) consist of plain steel when the rooms or cabins are used in the lower range of frequencies and, when the rooms or cabins are used in the upper range of frequencies, of a material which conducts electricity well and the surface of which is coated with austenitic steel (3, 4) at least in the contact zone.

2. Electrical contact device according to Claim 1, characterized in that copper or aluminium is provided as material which conducts electricity well.

3. Electrical contact device according to Claim 1, characterized in that chromium steel or nickel-chromium steel is provided as austenitic steel.

4. Electrical contact device according to Claim 1 to 3, characterized in that for using the rooms or cabins in the entire range of frequencies the spring chamber (1) and knife-like extension (2) consists of plain steel, which is coated with a first layer of material which conducts electricity well, and, at least in the contact zone, is coated with a second layer of austenitic steel.

**Revendications**

1. Dispositif de contact disposé entre des éléments constitutifs, mobiles les uns par rapport aux autres, de locaux ou de cabines protégés vis-à-vis des effets électromagnétiques, notamment de portes ou de fenêtres, et dans lequel dans un élément se trouve ménagé un logement pour ressorts, dans lequel sont insérés des ressorts de contact établissant un bon contact électrique avec cet élément, et sur l'autre élément se trouve prévu un prolongement en forme de couteau, qui, dans la position fermée, pénètre dans le logement pour ressorts de sorte que les ressorts de contact s'appliquent élastiquement contre ce couteau, caractérisé par le fait que le logement (1) pour ressorts et le prolongement (2) en forme de couteau sont réalisés en un acier non allié dans le cas de l'utilisation des locaux ou des cabines dans la plage des fréquences inférieures, et en un matériau bon conducteur de l'électricité dans le cas de l'utilisation des locaux et cabines dans la plage des fréquences supérieures, ce matériau étant recouvert, au moins dans la zone de contact, par de l'acier austénitique (3, 4).

2. Dispositif de contact suivant la revendication 1, caractérisé par le fait qu'il est prévu du cuivre ou de l'aluminium comme matériau bon conducteur de l'électricité.

3. Dispositif de contact suivant la revendication 1, caractérisé par le fait qu'il est prévu de l'acier au chrome ou de l'acier au chrome-nickel en tant qu'acier austénitique.

4. Dispositif de contact suivant les revendications 1 à 3, caractérisé par le fait que, dans le cas de l'utilisation des locaux ou des cabines dans la plage complète des fréquences, le logement (1) pour ressorts et le prolongement (2) en forme de couteau sont constitués par un acier non allié, qui est recouvert par une première couche formée d'un matériau bon conducteur de l'électricité et, au moins dans la zone de contact, par une seconde couche formée d'acier austénitique.

FIG 1

FIG 2

FIG 3